# EUROPÄISCHE PATENTSCHRIFT

(11) **EP 0 657 996 B1**
(45) Veröffentlichungstag und Bekanntmachung des Hinweises auf die Patenterteilung: **11.04.2001**
(21) Anmeldenummer: 94119072.0
(22) Anmeldetag: 02.12.1994
(51) Int. Cl.: H03G 1/00, H03G 1/04

(54) **In der Verstärkung umschaltbare Verstärkerstufe**
Amplifying stage with adjustable amplification
Etage amplificateur avec amplification ajustable

(30) Priorität: 06.12.1993 DE 4341507
(43) Veröffentlichungstag der Anmeldung: 14.06.1995
(73) Patentinhaber: Infineon Technologies AG, 81669 München (DE)
(72) Erfinder: Fenk, Josef, D-85386 Eching (DE); Ganser, Siegfried, D-80798 München (DE)
(74) Vertreter: Zedlitz, Peter, Dipl.-Inf.

(56) Entgegenhaltungen:
- EP-A- 0 085 872
- US-A- 4 520 324
- PATENT ABSTRACTS OF JAPAN vol. 014 no. 070 (E-0886) ,8.Februar 1990 & JP-A-01 288101 (IWATSU ELECTRIC CO LTD) 20.November 1989,

## Beschreibung

Die Erfindung betrifft eine rauscharme, in der Verstärkung umschaltbare Verstärkerstufe nach dem Oberbegriff des Patentanspruchs 1.

Aus DE 32 04 430 A1 ist ein solcher Differenzverstärker bekannt, der eine Kaskodestufe und eine Referenzspannungsquelle aufweist.

Derartige rauscharme Verstärkerstufen werden insbesondere in der Hochfrequenztechnik für Empfangsschaltungen, z.B. im Mobilfunk für Frequenzbereiche von z.B. bis zu 2 GHz, verwendet.

Anforderungen an derartige Verstärkerschaltungen sind, daß sie integrierbar sind, mit einer geringen Versorgungsspannung betreibbar sein sollen und daß die Verstärkung umschaltbar sein soll, wobei eine integrierte Ansteuerung des Schaltzustandes gewährleistet bleibt.

Bislang wurden derartige rauscharme Vorverstärker diskret aus hochwertigen Einzelhalbleitern aufgebaut.

Eine in der Verstärkung umschaltbare integrierbare Verstärkerstufe ist aus JP-A- 1 288 101 bekannt.

Aufgabe der vorliegenden Erfindung ist es, eine spezielle Ausführung einer in der Verstärkung umschaltbare integrierbare Verstärkerstufe anzugeben.

Diese Aufgabe wird durch den kennzeichnenden Teil des Anspruchs 1 gelöst. Vorteilhafte Weiterbildungen sind Kennzeichen der Unteransprüche.

Vorteil der Erfindung ist es, daß bei Wechsel der Verstärkung die Eingangsimpedanz der Schaltung kaum geändert wird.

Die Erfindung wird nachfolgend anhand von drei Figuren näher erläutert. Es zeigen
- Figur 1: eine Ausführungsform einer erfindungsgemäßen Schaltungsanordnung,
- Figur 2: eine erste Referenzspannungsquelle,
- Figur 3: eine zweite Referenzspannungsquelle.
- Figur 4: eine weitere Ausführungsform einer erfindungsgemäßen Schaltungsanordnung.

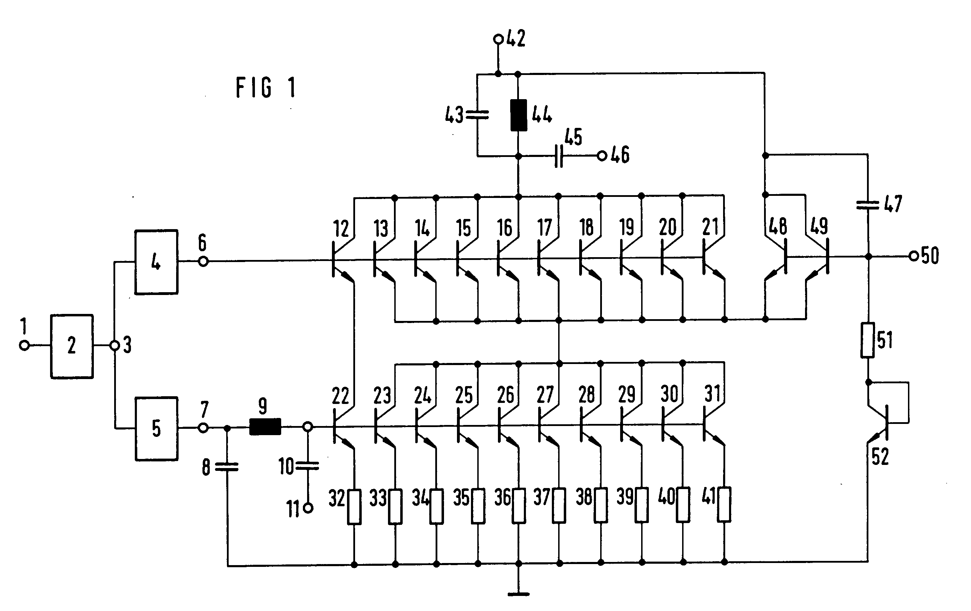

In Figur 1 ist mit 1 beispielsweise eine Versorgungsspannungsklemme bezeichnet, die eine Referenzspannungsquelle 2 versorgt. Die Referenzspannung der Referenzspannungsquelle 2 ist an einer Klemme 3 abgreifbar und wird zwei weiteren Referenzspannungsquellen 4 und 5 zugeführt. Diese erzeugen jeweils an ihren Ausgängen 6 bzw. 7 zwei voneinander unabhängige Referenzspannungen. Die erste Referenzspannung an der Ausgangsklemme 6 wird den Basisanschlüssen von npn-Transistoren 12 bis 21 zugeführt. Die Kollektoren der Transistoren 12 bis 21 sind miteinander und über einen Parallelschwingkreis 43, 44, der extern an die Schaltung gekoppelt sein kann, mit einer weiteren Versorgungsspannungsklemme 42 verbunden. Diese Versorgungsspannungsklemme 42 kann auch mit der Versorgungsspannungsklemme 1 übereinstimmen. Desweiteren ist eine Ausgangsklemme 46 vorgesehen, die über eine Kapazität 45 mit den miteinander verbundenen Kollektoren der Transistoren 12 bis 21 verbunden ist. Die an der Ausgangsklemme 7 abgreifbare zweite Referenzspannung wird über eine Drosselspule 9 den Basisanschlüssen von npn-Transistoren 22 bis 31 zugeführt. Der Kollektor des Transistors 22 ist mit dem Emitter des Transistors 12 verbunden. Die Kollektoren der Transistoren 23 bis 31 und die Emitter der Transistoren 13 bis 21 sind miteinander verbunden. Jeder Emitter der Transistoren 22 bis 31 ist über jeweils einen Widerstand 32 bis 41 mit Masse verschaltet. Eine Eingangsklemme 11 ist vorgesehen, die über eine Kapazität 10 mit den Basisanschlüssen der Transistoren 22 bis 31 verbunden ist. Die Ausgangsklemme 7 der zweiten Referenzspannungsquelle ist desweiteren über eine Kapazität 8 mit Masse verbunden. Die Spannungsversorgungsklemme 42 ist über Kapazität 47 mit einer Steuereingangsklemme 50 verschaltet. Desweiteren ist sie mit den Kollektoren der Transistoren 48 und 49 verbunden. Die Basisanschlüsse der Transistoren 48 und 49 sind mit der Steuereingangsklemme 50 verschaltet. Die Emitter der Transistoren 48 und 49 sind mit den Emittern der Transistoren 13 bis 21 verschaltet. Die Steuereingangsklemme 50 ist über eine Reihenschaltung bestehend aus einem Widerstand 51 und einer in Flußrichtung geschalteten Diode 52 mit Masse verbunden.

Wie bereits zuvor erwähnt sind beispielsweise alle Elemente bis auf die Kondensatoren 8, 10, 43, 45 und 47 und die beiden Spulen 9 und 44 integrierbar.

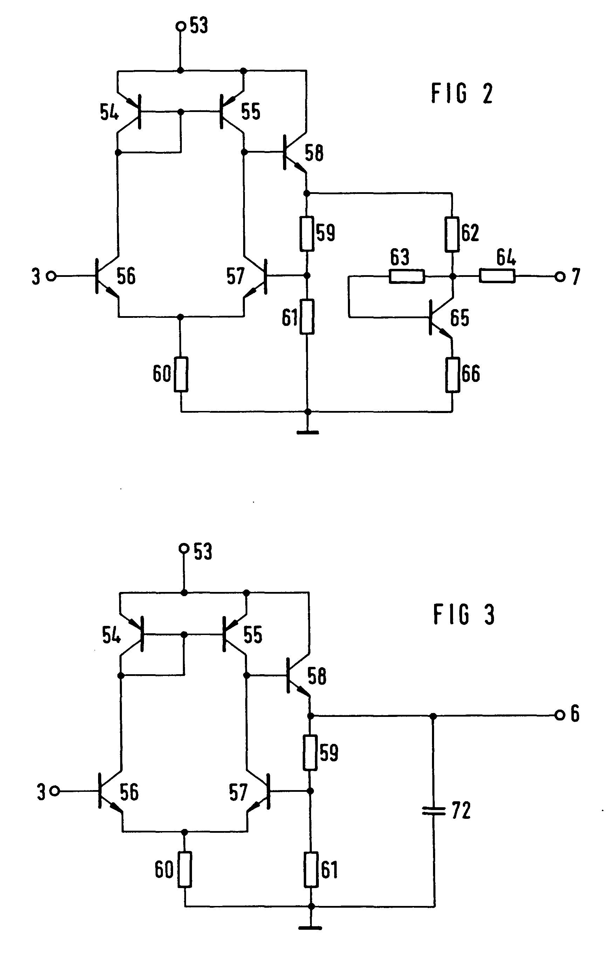

Die Referenzspannung an der Ausgangsklemme 3 kann z.B. durch eine Bandgap-Schaltung temperatur- und versorgungsspannungsunabhängig sein. Diese Referenzspannung dient dann zur Erzeugung der zwei weiteren Referenzspannungen an den Ausgangsklemmen 6 und 7. Die Referenzspannung an der Ausgangsklemme 7 gelangt über die Drossel 9 an die Basis der Transistoren 22 - 31. Die Referenzspannung an der Ausgangsklemme 6 wird direkt dem ersten Eingang einer durch die Transistoren 12 bis 21 und 48, 49 gebildeten Differenzverstärkerstufe zugeführt, wobei der Kondensator 72 (Fig. 3) für die hochfrequente Erdung der Basen im Transistor 12-21 dient. Über die Eingangsklemme 50 kann die Verstärkung der Differenzverstärkerstufe geschaltet werden. Das zu verstärkende Frequenzsignal wird an der Eingangsklemme 11 eingespeist und über die Kaskodestufe gedämpft oder verstärkt. Im dargestellten Beispiel kann dies z.B. zum einen -5 dB bzw. +15 dB sein. Über die zusammengeschalteten Kollektoren der Transistoren 12 bis 21 gelangt dieses Signal nach außen an einen externen Schwingkreis 43, 44 zur selektiven Auskopplung. Der Schwingkreis 43, 44 ist mit der Versorgungsspannung verbunden und bestimmt mit seiner Güte und der verwendeten Auskopplung die maximale Verstärkung des rauscharmen Verstärkers.

Die Kapazität 47 dient zum Abblocken unerwünschter Störungen, die Widerstände 32 bis 41 zur Erhöhung der Stromgegenkopplung, d.h. zur Linearisierung, der unteren Kaskodetransistoren 22 bis 31. Die Kombination des Widerstands 51 und des als Diode geschalteten Transistors 52 zieht das Potential an der Steuereingangsklemme 50 bei abgeschalteter Ansteuerung ca. auf 0,5 Volt, was einem logischen "0"-Pegel entspricht und schaltet so die maximale Verstärkung des rauscharmen Verstärkers ein.

Die Verstärkungseinstellung wird durch die Auftrennung der Kollektorleitungen der Transistoren 22 bzw. der Transistoren 23 bis 31 über die Kaskodetransistoren 12 bzw. 13 bis 21 erzielt. Sind die Transistoren 48 und 49 im Sperrzustand, so fließt der ganze Gleich- und Signalwechselstrom über die Kollektorleitungen der Transistoren 22 bis 31 und über die der Transistoren 12 bis 21 zum Ausgang, d.h. zu den kurzgeschlossenen Kollektoren der Transistoren 12 bis 21. Dies entspricht dem Zustand maximaler Verstärkung. Wird über den Schalteingang 50, durch einen High-Pegel, auf minimale Verstärkung umgeschaltet, dann fließt der Kollektor-Gleich- und Wechselstrom der Transistoren 23 bis 31 über die Kaskodetransistoren 48 und 49 ab, während die Transistoren 13 bis 21 gesperrt sind, so daß an dem Ausgang nur der Gleich- und Wechselstromanteil des Transistors 22 über den Transistor 12 abfließen kann. Die Aufteilung der Kollektorleitungen der Transistoren 22 bis 31 wurde im dargestellten Beispiel auf einen Wert der Verstärkungsänderung von 20 dB eingestellt.

Es ist jedoch eine beliebige andere Aufteilung je nach Verstärkungsänderung wählbar. Desgleichen kann die Zahl der paralleler Transistoren aufgespaltet werden, um eine gewünschte Verstärkungsänderung in mehreren Werten der Verstärkungseinstellung zu erreichen.

Figur 2 zeigt eine Ausführungsform einer Referenzspannungsquelle gemäß dem Bezugszeichen 5 in Figur 1. Diese Referenzspannungsquelle weist eine Versorgungsspannungsklemme 53 auf, die mit der Versorgungsspannungsklemme 42 bzw. 1 gemäß Figur 1 identisch sein kann. Diese ist mit den Emittern zweier pnp-Transistoren 54 und 55 verschaltet. Die Basisanschlüsse der beiden Transistoren 54 und 55 sind miteinander und mit dem Kollektor des Transistors 54 verbunden. Der Kollektor des Transistors 54 ist weiterhin mit dem Kollektor eines npn-Transistors 56 verschaltet. Die Basis des Transistors 56 ist mit einer Eingangsklemme 3 verschaltet. Der Kollektor des Transistors 55 ist mit dem Kollektor eines npn-Transistors 57 verbunden. Der Emitter des Transistors 57 ist mit dem Emitter des Transistors 56 verschaltet und über einen Widerstand 60 mit Masse verbunden. Die Versorgungsspannungsklemme 53 ist desweiteren mit dem Kollektor eines npn-Transistors 58 verbunden. Dessen Emitter ist über einen Widerstand 59 mit der Basis des Transistors 57 verschaltet. Die Basis des Transistors 58 ist mit dem Kollektor des Transistors 55 verbunden. Die Basis des Transistors 57 ist über einen Widerstand 61 mit Masse verschaltet. Das Ausgangssignal der Referenzspannungsquelle wird am Emitter des Transistors 58 abgegriffen und über die Reihenschaltung zweier Widerstände 62 und 64 einer Ausgangsklemme 7 zugeführt. Am Knotenpunkt der Reihenschaltung der Widerstände 62 und 64 ist der Kollektor eines npn-Transistors 65 geschaltet. Die Basis des Transistors 65 ist über einen Widerstand 63 mit seinem Kollektor verbunden. Der Emitter des Transistors 65 ist über einen Widerstand 66 mit Masse verschaltet.

Die in Figur 2 dargestellte Referenzspannungsquelle dient dazu, die Arbeitspunkte der Transistoren 22 bis 31 einzustellen. Dies wird über eine thermisch gekoppelte Stromspiegelschaltung mittels dem Transistor 65 realisiert. Die Basis der Transistoren 22 bis 31 werden dann über den Widerstand 64 und das externe Drosselelement 9 versorgt. Dabei hat der Widerstand 66 vorzugsweise den gleichen Wert wie die Widerstände 32 bis 41 und der Widerstand 63 vorzugsweise den zehnfachen Wert des Widerstands 64.

Figur 3 zeigt eine Ausführungsform für eine Referenzspannungsquelle gemäß dem Symbol 4 aus Figur 1. Die Anordnung entspricht im wesentlichen der in Figur 2, so daß gleiche Elemente gleiche Bezugszeichen haben. Bei der Referenzspannungsquelle gemäß Figur 3 wird jedoch die Ausgangsspannung am Emitter des Transistors 58 direkt der Ausgangsklemme 6 zugeführt. Zwischen Ausgangsklemme 6 und Masse ist eine integrierbare Kapazität 72 geschaltet, die zum Abblocken unerwünschter Störungen dient.

In einer Weiterbildung der erfindungsgemäßen Anordnung können eine Vielzahl weiterer schaltbarer Verstärkerstufen gemäß der Verstärkerstufe bestehend aus den Transistoren 13 bis 21 und 23 bis 31 sowie der zugehörigen Ansteuerstufe 47 bis 52 aus Figur 1 parallel geschaltet werden um eine stufenweise schaltbare Verstärkung zu gewährleisten. Die Verstärkerstufe kann dabei aus zwei Transistoren oder weiteren diesen parallel geschalteten Transistoren bestehen, je nach Verstärkungsgrad.

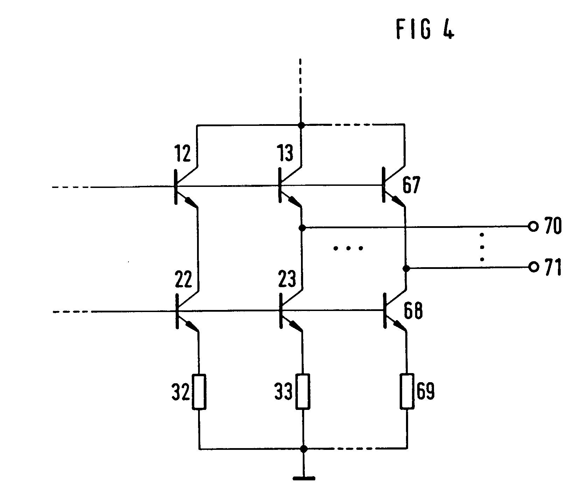

Eine derartige Anordnung ist in Figur 4 gezeigt. In Figur 4 ist nur ausschnittweise der schaltbare Differenzverstärker gemäß Figur 1 dargestellt. Gleiche Elemente weisen gleiche Bezugszeichen auf. Die zweite Differenzverstärkerstufe besteht hier beispielsweise nur aus zwei in Reihe geschalteten Transistoren 13 und 23. Zusätzlich sind weitere schaltbare Stufen vorgesehen. Dargestellt ist jedoch nur eine weitere bestehend aus den parallel zu den anderen beiden Stufen geschalteten Reihenschaltung aus den Laststrecken der Transistoren 67 und 68 sowie dem Widerstand 69. Der Knotenpunkt der Laststrecken der Transistoren 13 und 23 wird symbolisch über die Klemme 70 angesteuert. Hier kann beispielsweise eine Anordnung gemäß Figur 1 bestehend aus den Elementen 47 bis 52 vorgesehen sein. Auf gleiche Art und Weise kann der Knotenpunkt der Laststrecken der Transistoren 67 und 68 durch eine ähnliche Anordnung über die Klemme 71 angesteuert werden.

Auf diese Weise kann eine in der Verstärkung digital ansteuerbare Verstärkerstufe mit n-Verstärkungsstufen ausgebildet werden. Die einzelnen Stufen können selbstverständlich wiederum aus beliebig vielen parallel geschalteten Reihenschaltungen von Transistoren gemäß Figur 1 bestehen.

## Patentansprüche

1. Rauscharme, in der Verstärkung umschaltbare Verstärkerstufe in Kaskodeschaltung,
- mit einer ersten Reihenschaltung der Laststrecken zweier Transistoren (12, 22), und eines ersten Widerstandes (32), der mit einer Bezugspotentialklemme verbunden ist,
- mit wenigstens einer zweiten Reihenschaltung der Laststrecken zweier Transistoren (13...21, 23...31; 67, 68), und eines zweiten Widerstandes (33...41; 69), der mit der Bezugspotentialklemme verbunden ist, wobei die zweite Reihenschaltung parallel zur ersten Reihenschaltung (12, 22, 32) geschaltet ist,
- bei der die Kollektoranschlüsse der jeweils ersten Transistoren (12...21; 67) der Reihenschaltungen parallel geschaltet und mit einer Ausgangsklemme (46) gekoppelt sind, wobei die Ausgangsklemme (46) über einen Schwingkreis (43, 44) mit einer Versorgungsspannungsklemme (42) verbunden ist,
- mit einer ersten und einer zweiten Referenzspannungsquelle (4, 5) versehen, wobei die erste Referenzspannungsquelle den Basisanschlüssen der jeweils ersten Transistoren (12...21; 67) der Reihenschaltungen zugeführt wird und die zweite Referenzspannung den Basisanschlüssen der jeweils zweiten Transistoren (22...31; 68) der Reihenschaltungen zugeführt wird, wobei die Basisanschlüsse der jeweils zweiten Transistoren der Reihenschaltungen mit einer Eingangsklemme (11) gekoppelt sind,
- bei der wenigstens ein Umschaltmittel (48, 49, 51, 52) den Verbindungspunkt der Laststrecken der Transistoren der jeweils zweiten Reihenschaltung in Abhängigkeit von einem Steuersignal mit der Versorgungsspannungsklemme (42) verbindet.

2. Verstärkerstufe nach Anspruch 1,
bei der die zweite Reihenschaltung aus einer Vielzahl parallel geschalteter erster und zweiter Transistoren besteht.

3. Verstärkerstufe nach einem der vorhergehenden Ansprüche,
bei der die zweite Referenzspannung über eine Drossel den Basisanschlüssen der jeweils zweiten Transistoren der Reihenschaltungen zugeführt wird.

## Claims

1. Low-noise, variable-gain amplifier stage in a cascode circuit,
- having a first series circuit comprising the load paths of two transistors (12, 22) and of a first resistor (32) which is connected to a reference-earth potential terminal,
- having at least one second series circuit comprising the load paths of two transistors (13...21, 23...31; 67, 68), and of a second resistor (33...41; 69) which is connected to the reference-earth potential terminal, with the second series circuit being connected in parallel with the first series circuit (12, 22, 32),
- in which the collector connections of each of the first transistors (12...21; 67) in the series circuits are connected in parallel and are coupled to an output terminal (46), with the output terminal (46) being connected via a tuned circuit (43, 44) to a supply voltage terminal (42),
- provided with first and second reference voltage sources (4, 5), with the first reference voltage source being supplied to the base connections of each of the first transistors (12...21; 67) in the series circuits, and the second reference voltage being supplied to the base connections of each of the second transistors (22...31; 68) in the series circuits, and with the base connections of each of the second transistors in the series circuits being coupled to an input terminal (11),
- in which at least one switching means (48, 49, 51, 52) connects the junction point of the load paths of the transistors in each second series circuit to the supply voltage terminal (42), depending on a control signal.

2. Amplifier stage according to Claim 1,
in which the second series circuit comprises a large number of parallel-connected, first and second transistors.

3. Amplifier stage according to one of the preceding claims,
in which the second reference voltage is supplied via an inductor to the base connections of each of the second transistors in the series circuits.

## Revendications

1. Etage amplificateur à faible bruit avec amplification ajustable monté en cascode,
- avec un premier montage en série des circuits de charge de deux transistors (12, 22) et d'une première résistance (32), laquelle est reliée à une borne de potentiel de référence,
- avec au moins un deuxième montage en série des circuits de charge de deux transistors (13 ... 21, 23 ... 31 ; 67, 68) et d'une deuxième résistance (33 ... 41 ; 69), laquelle est reliée à la borne de potentiel de référence, le deuxième montage en série étant monté en parallèle avec le premier montage en série (12, 22, 32),
- dans lequel les bornes de collecteur de chacun des premiers transistors (12 ... 21 ; 67) des montages en série sont montées en parallèle et couplées à une borne de sortie (46), la borne de sortie (46) étant reliée via un circuit oscillant (43, 44) à une borne de tension d'alimentation (42),
- avec une première et une deuxième source de tension de référence (4, 5), la première source de tension de référence étant amenée aux bornes de base de chacun des premiers transistors (12 ... 21 ; 67) des montages en série et la deuxième tension de référence étant amenée aux bornes de base de chacun des deuxièmes transistors (22 ... 31 ; 68) des montages en série, les bornes de base de chacun des deuxièmes transistors des montages en série étant couplées à une borne d'entrée (11),
- dans lequel au moins un moyen de commutation (48, 49, 51, 52) relie en fonction d'un signal de commande, le point de liaison des circuits de charge des transistors de chaque deuxième montage en série à la borne de tension d'alimentation (42).

2. Etage amplificateur selon la revendication 1, dans lequel le deuxième montage en série est composé d'une pluralité de premiers et de deuxièmes transistors montés en parallèle.

3. Etage amplificateur selon l'une des revendications précédentes, dans lequel la deuxième tension de référence est amenée via une inductance aux bornes de base de chacun des deuxièmes transistors des montages en série.
